# EUROPEAN PATENT APPLICATION

(11) **EP 3 503 200 A1**
(43) Date of publication of application: **26.06.2019**
(21) Application number: 17209966.5
(22) Date of filing: 22.12.2017
(51) Int. Cl.: H01L 29/66, G11C 11/22, H01L 29/78, H01L 21/28, H01L 29/51

(54) **A FE-FET MEMORY DEVICE, AND A METHOD FOR PROGRAMMING SUCH A DEVICE**

(71) Applicant: IMEC vzw, 3001 Leuven (BE)
(72) Inventor: SALAHUDDIN, Shairfe Muhammad, 3001 Leuven (BE); SPESSOT, Alessio, 3001 Leuven (BE); VAN HOUDT, Jan, 3001 Leuven (BE); RYCKAERT, Julien, 3001 Leuven (BE)
(74) Representative: AWA Sweden AB

(57) **Abstract**

According to an aspect of the present inventive concept there is provided a FeFET memory device configured such that a ferroelectric memory region of the FeFET is programmable by an electric field applied between a gate structure and a source and drain region through the ferroelectric region.

## Description

### Technical field

The present inventive concept relates to a FeFET memory device, in particular it relates to a FeFET memory device which can be programmed by applying an electric field between the gate structure and source and drain region.

### Background

With the development of the semiconductor industry, memory devices having a higher density per unit area are generally in demand. Ferroelectric memories are nonvolatile memory devices including a ferroelectric material storing the logic state of the cell.

The conventional FeFETs are programmed by applying a voltage across gate and body capacitor. This programming approach however not suitable for modern nano-scale devices, in which the body may be difficult to access.

There is thus a need for improvements within this context.

### Summary

An objective of the present inventive concept is to provide a FeFET memory device which can be programmed by applying an electric field between the gate structure and source and drain region.

According to an aspect of the present inventive concept there is provided a FeFET memory device, comprising:
- a source region and a drain region separated by a channel region;
- a gate structure arranged to interact with the channel region;
- a dielectric structure arranged between the gate structure and the channel region;
- the dielectric structure further at least partly arranged between the gate structure and the source region, and between the gate structure and the drain region;
- wherein the dielectric structure comprising a ferroelectric memory region,
- wherein the gate structure defines a first overlap region with the source region, and a second overlap region with the drain region,
- wherein a ratio between a combined area of the first and second overlap regions and an area of an interface between the dielectric structure and the channel region is adapted such that the ferroelectric memory region is programmable by an electric field applied between the gate structure and source and drain region through the ferroelectric region.

As used herein, a "gate structure" refers to a gate of the a FeFET memory device, possibly including any insulating layers (e.g. gate dielectric). In the context of a memory devices, such gate is often referred to as a control gate.

The "area of an interface between the dielectric structure and the channel region" is often referred to as the effective channel region.

The first and second overlap regions is often referred to as "gate overlap". In the present invention, the gate structure will thus overlap at least the edges of the source and drain regions.

Conventional FeFETs are programmed by applying a voltage across gate and body capacitor. This programming approach however is incompatible with modern nano-scale devices such as FD-SOI MOSFET, FinFET, gate all around FETs, and nanowires as the body is tends to be difficult to access. The inventors have realized that by increasing the coupling area between the gate structure and the source region and the drain region, such that this region is larger than or comparable with, the effective channel region, the ferroelectric memory region is programmable by an electric field applied between the gate and source and drain region through the ferroelectric region.

In other words, for solving mentioned problem, low doped source/drain-to-gate overlaps is advantageously created and by ensuring that the length of the overlapped regions is larger than, or comparable with, the effective channel length, the ferroelectric memory region is programmable by an electric field applied between the gate and source and drain region, thus programmed without accessing the body. Moreover, the device may be programmable without applying any negative gate voltage. During programming with high gate voltage, the threshold voltage of the FeFET according to this embodiment is reduced as compared to the nominal device. During programming with low gate voltage, the threshold voltage of the source/drain-to-gate overlap regions is increased as compared to the device that is programmed with high gate voltage. The device, therefore, provides two different on currents depending on the programming condition and the device. Moreover, the device according to this embodiment allows a reduction in programming power, as well as a smaller footprint as no body separation between a plurality of FeFET memory devices is required. If access to the body is required for programming the FeFET memory device, it is required that a FeFET memory device has its own body (can also be called well). But with the present invention, a plurality of FeFET memory devices may share the same body, thus removing the need of body separation, and thus reducing the footprint.

According some embodiments, the gate structure defines a gate length, and wherein a combined length of the first and second overlap regions is at least 5% of the gate length. According to other embodiments, a combined length of the first and second overlap regions is at least 10%, 20% or 25% of the gate length

According some embodiments, the combined area of the first and second overlap regions is larger than the area of an interface between the dielectric structure and the channel region.

According some embodiments, the dielectric structure comprises a region between the gate and the interface between the dielectric structure and the channel region, and wherein said region comprises a non-ferroelectric high-k material. As the Vt shift of the channel region has a less impact on the device characteristics than the overlaps regions, the ferroelectric material on top of the effective channel can be replaced by the regular high-k gate material to improve read window. Therefore, it is advantageous to have a FeFET device structure that doesn't have a ferroelectric on the effective channel. This device provides maximum read window.

According some embodiments, the ferroelectric memory region further extends to a position besides the gate in a current flow direction of the channel. It has been observed that the on-current of the proposed FeFET device is dominated by the threshold voltage of the source/drain-to-gate overlap regions. By improving the gate control over the overlap regions, e.g. by extending the ferroelectric memory region as defined in this embodiment, the Vt shift during programming will be improved. By the term "current flow direction of the channel, it should be understood a direction from the source region to the drain region, and vice versa, through the channel.

According some embodiments, the dielectric structure further comprises two further dielectric structures positioned beside the gate in a current flow direction of the channel. Such further dielectric structures may often be called "spacers". As described above, by improving the gate control over the overlap regions, the Vt shift during programming will be improved. The proposed FeFET with ferroelectric gate-spacers will provide an increased read window.

The FeFET memory device may be a FD-SOI (fully depleted silicon on insulator), a PD-SOI (fully depleted silicon on insulator) or a single gate bulk ferro-FET. In these embodiments, the device further comprises a substrate, wherein a surface portion of the substrate comprises:
- the source region and the drain region separated by the channel region,
- wherein the gate structure is arranged above the channel region, the gate structure having a first surface facing the surface portion of the substrate;

According to some embodiments, a projection of the gate on the surface portion of the substrate overlaps with the source and drain region, the area of the overlap being larger than the area of the interface between the dielectric structure and the channel region of the FeFET memory device. In this embodiment, the effective channel area is reduced, and the gate-source-drain overlap is increased, which further reduces the importance of the channel Vt shift. As described above, according to some embodiments, the area of the overlap is at least 5% of the gate length. According to other embodiments, the area of the overlap is larger than the area of an interface between the dielectric structure and the channel region.

According to some embodiments, the gate structure has a second surface not facing the surface portion of the substrate, wherein the ferroelectric memory region comprises an interface with said first and second surface.

According to some embodiments, the two further dielectric structures are laterally positioned to the gate in respect to the first surface of the gate.

The FeFET memory device may be a finFET device. In this embodiment, the device further comprises a substrate, wherein a surface portion of the substrate comprises;
- the source region and the drain region separated by a fin shaped channel region, wherein the gate structure is extending over the channel region;
- the dielectric structure arranged between the gate structure and the channel region.

The FeFET memory device may be a gate-all around device. In this embodiment, the gate structure is arranged to at least partly enclose the channel region, wherein the dielectric structure is formed on an inside surface of the gate structure, wherein the channel is extending through the gate structure, wherein the gate structure further at least partly enclose at least parts of the source region and the drain region.

According to a second aspect of the present inventive concept, there is provided a method for programming a FeFET memory device according to the first aspect, comprising:
- writing a first logic state to the ferroelectric memory by providing a first voltage difference between the gate structure and the drain and the source;
- writing a second logic state to the ferroelectric memory by providing a second voltage difference between the gate structure and the drain and the source.

According to some embodiments, the first voltage difference is achieved by providing a supply voltage to the gate and a ground to the source and drain.

According to some embodiments, the second voltage difference is achieved by providing a supply voltage to the source and drain and a ground to the gate.

The second aspect may generally present the same or corresponding advantages as the first aspect.

### Brief description of the drawings

The above, as well as additional objects, features and advantages of the present inventive concept, will be better understood through the following illustrative and non-limiting detailed description, with reference to the appended drawings. As illustrated in the figures, the sizes of layers and regions are exaggerated for illustrative purposes and, thus, are provided to illustrate the general structures of embodiments of the present invention. Like reference numerals refer to like elements throughout unless stated otherwise.
Fig. 1 is a schematic view of a planar single gate FeFET memory device in cross section according to a first embodiment.
Fig. 2 is a schematic view of a planar single gate FeFET memory device in cross section according to a second embodiment.
Fig. 3 is a schematic view of a planar single gate FeFET memory device in cross section according to a third embodiment.
Fig. 4 is a schematic view of a planar single gate FeFET memory device in cross section according to a fourth embodiment.
Fig. 5 is a schematic view of a multigate FeFET memory device in cross section according to a first embodiment.
Fig. 6 is a schematic view of a multigate FeFET memory device in cross section according to a second embodiment.

### Detailed description

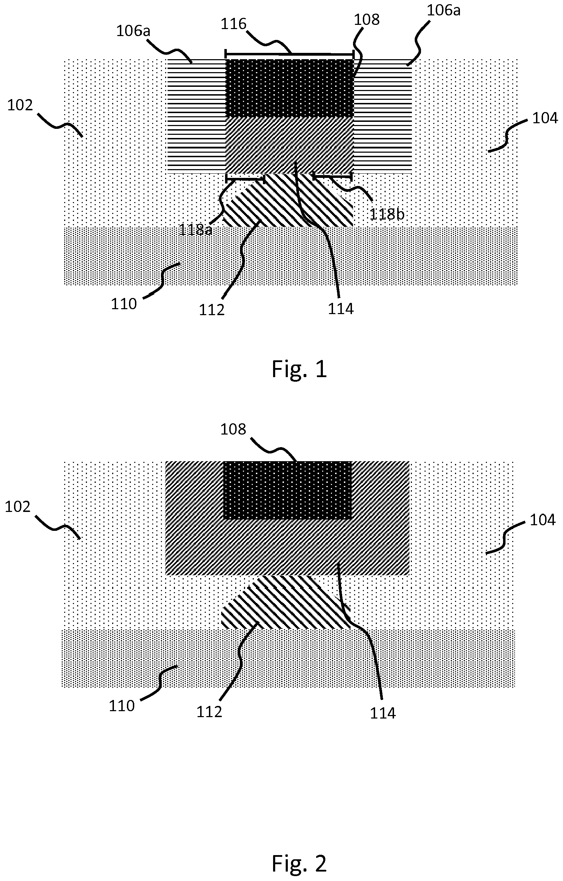

Fig. 1 illustrates a first embodiment of a planar single gate memory device (such as single gate bulk ferro-FET, PD-SOI, PD-SOI). The device comprises a substrate 110. The substrate 110 may be a bulk oxide structure, but the substrate may also be divided into layers, e.g. a lower oxide layer and a partly depleted silicon layer on top of the lower oxide layer. On a surface of the substrate 110 there is provided a source region 102 and a drain region 104. The source 102 and drain 104 are separated by a channel region 112. The material of the channel region may be a crystalline semiconductor material such as e.g. Si. Above the channel region 112, there is provided a gate structure 108. Moreover, there is provided a dielectric structure 114, 106a, 106b arranged between the gate structure 108 and the channel region 114. The dielectric structure 114, 106a, 106b comprising a ferroelectric memory region 114, e.g. from a Hf-based ferroelectric material. As can be seen in figure 1, an upper part of the channel region 112 may be narrowed towards the ferroelectric memory region 114. This may e.g. be achieved by means of doping, forming LDD/HDD junctions, such that an effective area of the channel region 112 (i.e. in the embodiment of figure 1, the area of an interface between the ferroelectric memory region 114 and the channel region 112), is reduced. In other words, a projection of the gate 108 on the surface portion of the substrate 110 overlaps with the source 102 and drain 104 regions and defines a first overlap region 118a with the source region, and a second overlap region 118b with the drain region. According to some embodiments, the gate structure defines a gate length 116, and wherein a combined length of the first 118a and second 118b overlap regions is at least 5% of the gate length 116. According to some embodiment, the combined area of the first 118a and second 118b overlap regions is larger than the area of an interface between the dielectric structure 114, 106a, 106b and the channel region 112. By the described embodiment, a ratio between a combined area of the first 118a and second 118n overlap regions and an area of an interface between the dielectric structure and the channel region (effective channel area) is adapted such that the ferroelectric memory region is programmable by an electric field applied between the gate structure and source and drain region through the ferroelectric region.

Moreover, in the embodiment of figure 1, there is provided two further dielectric structures 106a, 106b laterally positioned to the gate 108 in respect to the first surface (lower surface in figure 1) of the gate 108 In other words, the dielectric structures 106a, 106b are provided beside the gate structure 108 in a current flow direction of the channel 112. Such structures may also be called spacers. The dielectric structures 106a-b may be formed by a ferroelectric material. Consequently, the read window of the device may be increased.

Fig. 2 illustrates a second embodiment of a planar single gate memory device (such as single gate bulk ferro-FET, PD-SOI, PD-SOI), similar to the embodiment of figure 1. However, in this embodiment, the ferro-electric memory region is provided around the gate structure 108. In other words, the gate structure 108 has a second surface not facing the surface portion of the substrate 110, wherein the ferroelectric memory region 114 comprises an interface with said first and second surface. In yet other words, the ferroelectric memory region 114 is provided also laterally positioned to the gate structure 108.

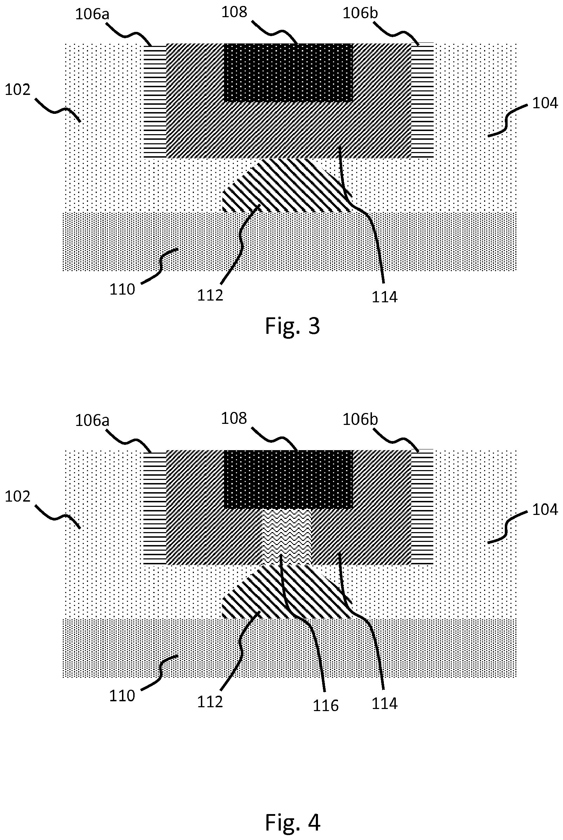

Fig. 3 illustrates a third embodiment of a planar single gate memory device (such as single gate bulk ferro-FET, PD-SOI, PD-SOI), similar to the embodiment of figure 2. In this embodiment, the ferroelectric memory region 114 is provided also laterally positioned to the gate structure 108, like in figure 2. Moreover, the read window of the device is further increased by providing spacers 106a, 106b outside the ferroelectric memory region 114, laterally positioned to the gate structure 108.

Fig. 4 illustrates a fourth embodiment of a planar single gate memory device (such as single gate bulk ferro-FET, PD-SOI, PD-SOI), similar to the embodiment of figure 3. However, in figure 4, a region between the gate 108 and the effective channel area comprises a non-ferroelectric high-k material 116, to provide an further increased read window for the device.

As described above, the inventive concept of this disclosure can further be implemented in a FinFET memory device. Fig. 4 illustrates such a device, where the figure is shown as a cross section in the y-z plan (a substrate is provided in the y-z plane), where the gate of the device is raising from the substrate along the x-axis. In this embodiment, the surface portion of the substrate (not shown but provided beneath the source and drain regions 102, 104 comprises a gate structure 108. The source region 102 and the drain region 104 is separated by a fin shaped channel region 112, wherein the channel region 112 extends through the gate structure 108. In other words, the gate structure 108 is extending over the channel region 112. The gate structure 108 may thus be in a form of an arch. Between the gate structure 108 and the channel region 112 is provided a dielectric structure 114, in this case a ferroelectric memory region 114. Optionally, there is provided spacers 106a-106b. The spacers 106a-106b (which may be from a ferroelectric material) may be shaped as the gate structure 108 and provided laterally positioned to the gate structure 108 in a y-direction. Alternatively, or additionally, the ferroelectric memory region 114 may extend to a position besides the gate in a current flow direction of the channel, and thus provided laterally positioned to the gate structure 108 in a y-direction. The gate structure 108 defines a first overlap region 118a with the source region 102, and a second overlap region 118b with the drain region 104. As described above, the gate structure 108 defines a gate length 116, and a combined length of the first 118a and second 118b overlap regions is at least 5% of the gate length 116. According to some embodiments, the combined area of the first 118a and second 118b overlap regions is larger than the area of an interface between the dielectric structure 114 and the channel region 112 (i.e. the effective channel area).

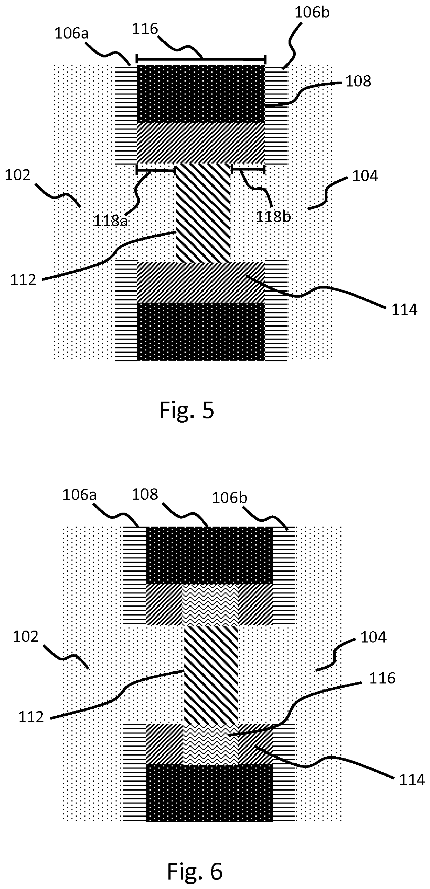

Fig. 6 illustrates a second embodiment of a multigate device, which is similar to the device of figure 5. In figure 6, the dielectric structure (in this case regions 114, 116, 106a, 106b) comprises a region 116 between the gate 108 and the effective channel area, wherein said region 116 comprises a non-ferroelectric high-k material.

The inventive concept may further be provided for a gate-all-around FeFET memory device. In this embodiment, the gate structure arranged to at least partly enclose the channel region (thus being substantially pipe shaped), wherein the dielectric structure is formed on an inside surface of the gate structure. I n this arrangement, the channel is thus extending through the gate structure. To increase the area of an interface between the dielectric structure and the source and drain regions, the gate structure further at least partly enclose at least parts of the source region and the drain region.

By the above disclosed inventive concept, programming of the FeFET memory device can be achieved without accessing the body of the device. The inventive concept thus includes a method for programming a FeFET memory device as described herein, the method comprising:
- writing a first logic state (e.g. a one) to the ferroelectric memory by providing a first voltage difference between the gate structure and the drain and the source;
- writing a second logic state (e.g. a zero) to the ferroelectric memory by providing a second voltage difference between the gate structure and the drain and the source.

An advantage of the device as described herein is that no negative voltage to programming the FeFET may be needed. This may be advantageous in that it reduces the power needed for programming the device, and that the control circuits of the device may be simplified. Consequently, the method of programming the device may comprise the step of achieving the first voltage difference by providing a supply voltage to the gate and a ground to the source and drain. Moreover, the method of programming the device may comprise the step of achieving the second voltage difference by providing a supply voltage to the source and drain and a ground to the gate.

Table 1 below disclose a preferred way of programming the device disclosed herein, compared to a conventional way of programming a FeFET. In the table, x stands for that no input current is needed for that part of the device.

**Table 1**

| | Write 0 | Write 0 | Write 1 | Write 1 |
|---|---|---|---|---|
| | Conventional | Inventive device | Conventional | Inventive device |
| V_{gate} | -V_{dd} or 0 | 0 | V_{dd} or 0 | V_{dd} |
| V_{drain} | X, or V_{body} | V_{dd} | X, or V_{body} | 0 |
| V_{source} | X, or V_{body} | V_{dd} | X, or V_{body} | 0 |
| V_{body} | 0 or V_{dd} | X | 0 or -V_{dd} | X |

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A FeFET memory device, comprising:
a source region and a drain region separated by a channel region;
a gate structure arranged to interact with the channel region;
a dielectric structure arranged between the gate structure and the channel region;
the dielectric structure further at least partly arranged between the gate structure and the source region, and between the gate structure and the drain region;
wherein the dielectric structure comprising a ferroelectric memory region,
wherein the gate structure defines a first overlap region with the source region, and a second overlap region with the drain region,
wherein a ratio between a combined area of the first and second overlap regions and an area of an interface between the dielectric structure and the channel region is adapted such that the ferroelectric memory region is programmable by an electric field applied between the gate structure and source and drain region through the ferroelectric region.

2. A FeFET memory device according to claim 1, wherein the gate structure defines a gate length, and wherein a combined length of the first and second overlap regions is at least 5% of the gate length.

3. A FeFET memory device according to claim 1, wherein the combined area of the first and second overlap regions is larger than the area of an interface between the dielectric structure and the channel region.

4. A FeFET memory device according to any one of claims 1-3, wherein the dielectric structure comprises a region between the gate and the interface between the dielectric structure and the channel region, and wherein said region comprises a non-ferroelectric high-k material.

5. A FeFET memory device according to any one of claims 1-4, wherein the ferroelectric memory region further extends to a position beside the gate in a current flow direction of the channel.

6. A FeFET memory device according to any one of claims 1-5, wherein the dielectric structure further comprises two further dielectric structures positioned beside the gate in a current flow direction of the channel.

7. A FeFET memory device according to any one of claims 1-6, further comprising a substrate, wherein a surface portion of the substrate comprises:
the source region and the drain region separated by the channel region,
wherein the gate structure is arranged above the channel region, the gate structure having a first surface facing the surface portion of the substrate;

8. A FeFET memory device according to claim 7,
wherein a projection of the gate on the surface portion of the substrate overlaps with the source and drain region, the area of the overlap being larger than the area of the interface between the dielectric structure and the channel region of the FeFET memory device.

9. A FeFET memory device according to any one of claims 7-8 when being dependent on claim 3, wherein the gate structure has a second surface not facing the surface portion of the substrate, wherein the ferroelectric memory region comprises an interface with said first and second surface.

10. A FeFET memory device according to any one of claims 7-9 when being dependent on claim 4, wherein the two further dielectric structures are laterally positioned to the gate in respect to the first surface of the gate.

11. A FeFET memory device according to any one of claims 1-6, being a finFET device, further comprising a substrate, wherein a surface portion of the substrate comprises;
the source region and the drain region separated by a fin shaped channel region, wherein the gate structure is extending over the channel region;
the dielectric structure arranged between the gate structure and the channel region;

12. A FeFET memory device according to any one of claims 1-6, wherein the gate structure is arranged to at least partly enclose the channel region, wherein the dielectric structure is formed on an inside surface of the gate structure, wherein the channel is extending through the gate structure, wherein the gate structure further at least partly enclose at least parts of the source region and the drain region.

13. A method for programming a FeFET memory device according to any one of claims 1-11, comprising:
writing a first logic state to the ferroelectric memory by providing a first voltage difference between the gate structure and the drain and the source;
writing a second logic state to the ferroelectric memory by providing a second voltage difference between the gate structure and the drain and the source.

14. A method according to claim 12, wherein the first voltage difference is achieved by providing a supply voltage to the gate and a ground to the source and drain.

15. A method according to claims 12-13, wherein the second voltage difference is achieved by providing a supply voltage to the source and drain and a ground to the gate.
